Europäisches Patentamt

European Patent Office

Office européen des brevets

(19)

(11) Numéro de publication : **0 246 938 B1**

(12) **FASCICULE DE BREVET EUROPEEN**

(45) Date de publication du fascicule du brevet :
04.09.91 Bulletin 91/36

(51) Int. Cl.⁵ : **H03K 17/969**

(21) Numéro de dépôt : **87400916.0**

(22) Date de dépôt : **21.04.87**

(54) Clavier à interruption de rayonnement.

(30) Priorité : 22.04.86 FR 8605774

(43) Date de publication de la demande :
25.11.87 Bulletin 87/48

(45) Mention de la délivrance du brevet :
04.09.91 Bulletin 91/36

(84) Etats contractants désignés :
AT BE CH DE ES FR GB GR IT LI LU NL SE

(56) Documents cités :
EP-A- 0 113 223
WO-A-86/01954
FR-A- 2 518 864

(56) Documents cités :
FR-A- 2 548 394
GB-A- 2 095 447
US-A- 3 603 982
US-A- 3 648 050
US-A- 4 417 824

(73) Titulaire : Battarel, Claude
La Cour
F-61420 FONTENAI LES LOUVETS (FR)

(72) Inventeur : Battarel, Claude
La Cour
F-61420 FONTENAI LES LOUVETS (FR)

(74) Mandataire : Bloch, Gérard et al
2, square de l'Avenue du Bois
F-75116 Paris (FR)

## Description

La présente invention a pour objet un clavier comprenant une matrice de touches, un émetteur de rayonnement par colonne de touches, un récepteur de rayonnement par ligne de touches, des moyens disposés à chaque croisement d'une colonne et d'une ligne, pour défléchir les rayonnements de l'émetteur correspondant vers le récepteur correspondant, des moyens commandés par chaque touche pour interrompre le rayonnement de l'émetteur correspondant, et des moyens pour commander les émetteurs de façon séquentielle et cyclique.

Un tel clavier permet l'entrée manuelle de données alphanumériques dans une machine de traitement de texte, un ordinateur, ou un terminal raccordé à un réseau de télécommunications, par exemple.

On connaît déjà un tel clavier, décrit dans le brevet US 4 417 824. Dans ce clavier, le rayonnement considéré est un rayonnement lumineux, chaque colonne comporte un premier guide de lumière, en matériau transparent d'indice plus grand que celui de l'air, à l'intérieur duquel se propage la lumière émise par l'émetteur correspondant, et chaque ligne comporte un deuxième guide de lumière, en même matériau que le premier guide, à l'intérieur duquel se propage la lumière reçue par le récepteur correspondant. Chaque moyen de déflexion du rayonnement d'un émetteur vers un récepteur comprend, dans le premier guide, ou guide d'émission, deux surfaces réfléchissantes pour faire sortir, hors du guide d'émission et dans une direction parallèle à celle du deuxième guide, ou guide de réception, une partie de la lumière émise, et, dans le guide de réception, une surface réfléchissante pour faire entrer la lumière sortie du guide d'émission. Chaque moyen d'interruption comprend un volet opaque qui vient s'interposer entre le guide d'émission et le guide de réception, pour interrompre le rayonnement lumineux.

Un tel clavier présente plusieurs inconvénients. Tout d'abord, le matériau transparent utilisé pour les guides n'étant pas parfait, la lumière s'y propage avec atténuation. De plus, afin d'être défléchi, le rayonnement de l'émetteur subit trois réflexions. Par ailleurs, pour entrer, puis sortir du guide d'émission, ce rayonnement doit franchir une interface air-milieu transparent puis une interface milieu transparent-air. Or, chaque réflexion ou passage d'interface donne naissance à des pertes d'énergie lumineuse. Ainsi, après propagation, réflexions et franchissements d'interface, la portion de lumière émise par un émetteur qui est reçue par un récepteur est relativement faible. Ceci diminue la sureté de fonctionnement du clavier et nécessite l'emploi de sources puissantes et de capteurs sensibles. Par ailleurs, l'emploi et la mise en place de guides d'émission de forme relativement complexe augmentent les coûts de fabrication.

La demande européenne EP-A-0 151 022 décrit par ailleurs un clavier matriciel comprenant un émetteur de lumière par colonne et un récepteur par ligne et des moyens pour commander les émetteurs de façon séquentielle et cyclique. Dans ce clavier, la lumière se propage dans l'air, à l'intérieur de canaux creux et rectilignes correspondants aux colonnes et aux lignes. Un tel clavier ne présente donc aucun des inconvénients précédents. Cependant, la lumière se propageant en ligne droite, et les colonnes étant sensiblement perpendiculaires aux lignes, il n'est pas possible d'utiliser, comme dans le brevet US 4 417 824, des touches commandant chacune un simple volet opaque. En effet, en l'absence de moyens de déflexion du rayonnement lumineux des émetteurs vers les récepteurs, aucun récepteur ne reçoit jamais la lumière d'aucun émetteur. Aussi, dans ce clavier, on utilise des touches qui commandent chacune la mise en place, au croisement d'une colonne, et d'une ligne, de moyens de déflexion du rayonnement lumineux de l'émetteur correspondant vers le récepteur correspondant. Ces moyens de déflexion sont, en l'occurrence, constitués par une surface réfléchissante inclinée par rapport au sens de propagation de la lumière dans la colonne, pour dévier une partie de la lumière émise d'un angle de sensiblement 90°, dans la direction de la ligne. Afin que l'enfoncement d'une touche n'interdise pas le passage de la lumière dans les canaux, on utilise soit une surface totalement réfléchissante commandée par la touche pour s'interposer sur une partie seulement de la section du canal de propagation, soit une surface semi-réfléchissante commandée par la touche pour s'interposer sur la totalité de la section du canal de propagation. Dans les deux cas, même si une touche est enfoncée, elle n'empêche pas totalement le passage de la lumière, ce qui permet la reconnaissance des touches enfoncées situées en aval, dans le sens de propagation du rayonnement, dans la même colonne, ou de celles situées en amont dans la même ligne.

Un clavier comme celui qui vient d'être décrit, s'il ne présente pas les défauts inhérents aux claviers utilisant des guides de lumière en matériau transparent d'indice supérieur à celui de l'air, présente cependant d'autres inconvénients. Tout d'abord, chacune des touches, commandant la mise en place d'une surface réfléchissante mobile dont l'angle d'inclinaison doit rester rigoureusement constant, est mécaniquement plus compliquée qu'une touche qui commande la mise en place d'un volet opaque dont l'angle d'inclinaison n'est pas critique. Par ailleurs, bien que l'enfoncement d'une touche ne provoque pas l'annulation de la lumière en aval de cette touche, il en provoque l'atténuation dans des proportions relativement importantes. Ceci diminue la sûreté de fonctionnement du clavier, et entraîne donc également l'emploi de sources puissantes et de capteurs sensibles.

La présente invention vise à pallier les inconvénients précédents.

A cet effet, elle a pour objet un clavier du type défini ci-dessus, caractérisé par le fait que chaque moyen d'interruption est en vue directe de l'émetteur correspondant, et chaque moyen de déflexion est disposé, sur le trajet du faisceau de l'émetteur correspondant, en aval du moyen d'interruption associé.

Dans la phase précédente, il est clair que le moyen de déflexion est disposé en aval de la position opératoire du moyen d'interruption.

Dans le clavier de l'invention, il n'y a aucune perte de lumière dans les lignes d'émission due à l'emploi d'un guide en matériau transparent, l'enfoncement d'une touche ne gêne pas la reconnaissance d'une touche située en aval dans la même ligne d'émission, et chaque touche reste mécaniquement très simple.

Avantageusement, chaque ligne comprend des moyens de guidage du rayonnement défléchi par les moyens de déflexion.

Les moyens de guidage permettent de guider le rayonnement de façon à ce que l'enfoncement d'une touche ne gêne pas la reconnaissance d'une touche située en amont dans la même ligne.

Avantageusement, encore ledit rayonnement est un rayonnement lumineux, et les moyens de guidage comprennent une barrette de matériau transparent audit rayonnement, et chaque moyen de déflexion comprend une surface réfléchissante de ladite barrette.

Dans un tel clavier, entre un émetteur et un récepteur, le rayonnement lumineux traverse un interface air-matériau transparent, subit une réflexion puis traverse une interface matériau transparent-air. La lumière franchit donc deux interfaces et subit une réflexion. Dans le clavier connu par le brevet US 4 417 824, elle franchit quatre interfaces et subit trois réflexions. Les pertes sont donc notablement plus faibles que dans ce clavier connu.

La présente invention sera mieux comprise à l'aide de la description suivante de la forme de réalisation préférée du clavier de l'invention, faite en se référant aux dessins annexés, sur lesquels,

– la figure 1 représente la partie inférieure du clavier de l'invention,

– la figure 2 représente une vue en coupe selon la ligne II-II de la figure 1,

– la figure 3 représente une vue en perspective d'une barrette du clavier de la figure 1,

– les figures 4a, 4b, 4c et 4d représentent une vue de dessous, de face, de dessus et de profil, respectivement, de la barrette de la figure 3,

– les figures 5a et 5b représentent chacune une vue simplifiée, en coupe, de deux touches du clavier de la figure 1 appartenant à des lignes différentes,

– la figure 5c représente une vue de dessus de l'anneau des touches des figures 5a et 5b,

– la figure 5d représente quatre configurations du volet des touches des figures 5a et 5b,

– la figure 6a représente une vue simplifiée, en coupe, d'une première variante de réalisation de la touche de la figure 5a,

– la figure 6b représente une vue en perspective du cabochon de la touche de la figure 6a, et,

– la figure 6c représente une vue de dessus de l'anneau de la touche de la figure 6a,

– la figure 7a représente une vue simplifiée, en coupe, d'une deuxième variante de réalisation de la touche de la figure 5a,

– la figure 7b représente une vue de dessus, en coupe, de la touche de la figure 7a,

– la figure 8a représente une vue en perspective d'une première variante de réalisation de la barrette de la figure 3,

– la figure 8b représente une vue de profil de la barrette de la figure 8a, et

– la figure 9 représente une vue de profil d'une deuxième variante de réalisation de la barrette de la figure 3.

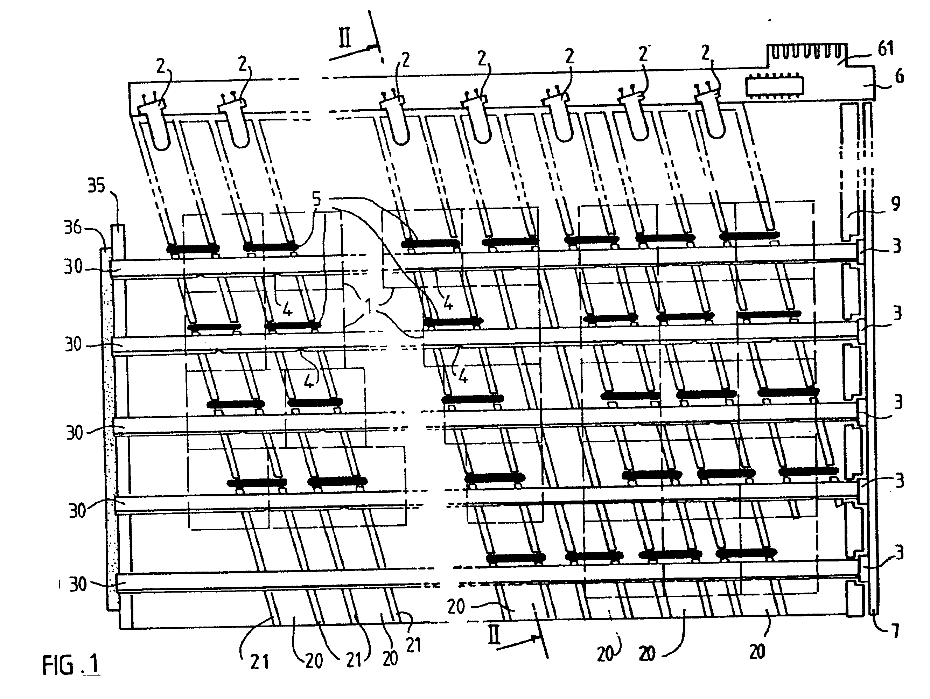

En référence à la figure 1, un clavier, pour entrer manuellement des données dans une machine de traitement d'information, par exemple, comprend une matrice de touches 1, représentées en pointillé sur la figure 1. A chaque colonne 20 de la matrice de touches correspond un émetteur de rayonnement, en l'occurrence une diode électroluminescente 2, disposée pour que les touches de la colonne 20 se trouvent sur le trajet du faisceau lumineux qu'elle émet. A chaque ligne 30 de la matrice de touches correspond un récepteur du rayonnement émis, en l'occurrence une photodiode 3, disposée pour pouvoir recevoir un rayonnement lumineux en provenance de chacune des touches de la ligne 30. Au croisement de chaque colonne 20 et de chaque ligne 30 sont disposés des moyens 4, qui seront décrits dans la suite, pour défléchir une partie de la lumière émise par la diode électroluminescente 2 correspondante vers la photodiode 3 correspondante. Chaque touche commande un moyen d'interruption du faisceau lumineux, en l'occurrence un volet opaque 5 qui vient s'interposer sur le trajet de ce faisceau.

En supposant qu'à un instant donné, seule la diode électroluminescente 2 de rang j soit commandée pour émettre un faisceau lumineux, l'examen des signaux de sortie des photodiodes 3 renseigne sur les touches 1 de la colonne de rang j qui sont enfoncées. Par exemple, si la photodiode de rang k délivre un signal de sortie nul, c'est que la touche située au croisement de la colonne de rang j et de la ligne de rang k est enfoncée. En commandant de façon suffisamment rapide les diodes électroluminescentes 2 de façon séquentielle et cyclique, et, simultanément, la lecture des photodiodes 3, un circuit électronique, par exemple à microprocesseur, et comprenant ici des plaquettes imprimées 6 et 7, délivre donc sur un connecteur 61 un signal de sortie correspondant à tout instant aux touches enfoncées, et assure la fonction connue par l'homme de métier sous le nom "N key roll-over".

Un circuit électronique de ce type est à la portée de l'homme de métier et il est identique à celui décrit dans le brevet US 4 417 824, par exemple.

Dans le clavier de l'invention, un canal creux rectiligne, délimité par des parois 21, ici réfléchissantes, correspond à chaque colonne 20. Chaque canal 20 est disposé dans l'axe de rayonnement de chaque diode électroluminescente 2.

Les diodes électroluminescentes 2 sont ici à diagramme de rayonnement étroit, en première approximation contenu dans un angle de ± 10° et de puissance totale rayonnée de l'ordre de 20 milliwatts pour un courant d'excitation de 100 milliampères à 20 degrés Celcius. De telles diodes, émettant à la longueur d'onde de 930 nanomètres, sont disponibles de manière courante.

Un guide de rayonnement lumineux, ici une barrette en matériau transparent d'indice supérieur à celui de l'air, correspond à chaque ligne 30. Chaque barrette 30 est disposée dans l'axe de réception de chaque photodiode 3. Les photodiodes 3 sont ici du type PIN. Les barrettes 30 sont réalisées ici dans un matériau du type acrylique d'indice sensiblement égal à 1,5, à la longueur d'onde utilisée. Les canaux 20 et les barrettes 30 forment ici un angle de l'ordre de 76°.

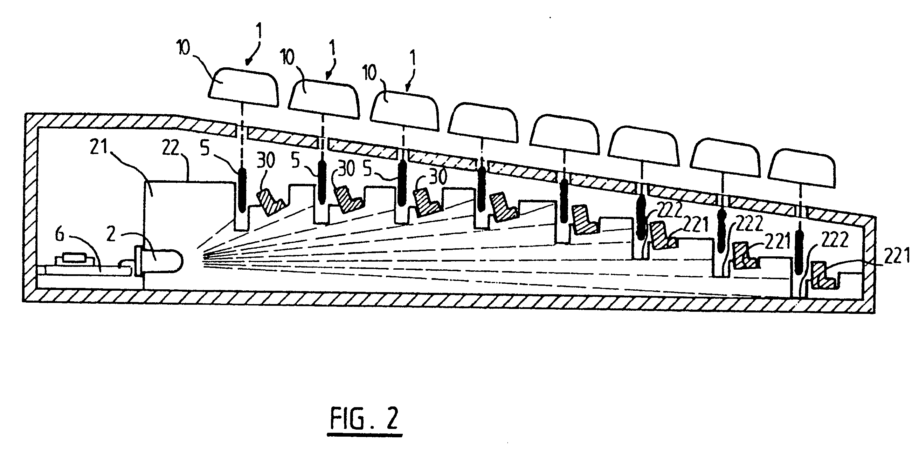

Comme le montre la figure 2, qui est une vue en coupe d'un canal 20, les parois 21, ici solidaire du fond du boîtier du clavier, ont un bord supérieur 22 agencé pour supporter les barrettes 30. Les barrettes 30 sont toutes identiques et ont une section droite sensiblement en forme de L. Les barrettes 30 s'appuient dans des évidements 221 du bord supérieur 22 de chaque paroi 21, de positions et de formes telles que la surface correspondant à la partie inférieure, situé sur la droite, de la barre sensiblement verticale du L de la section droite de chaque barrette 30 se trouve en vue directe de la diode électroluminescente 2.

Le bord supérieur 22 de chaque paroi 21 comprend également des évidements 222 qui permettent à chaque volet 5 solidaire du cabochon 10 de chaque touche 1 de venir s'interposer sur le trajet du faisceau lumineux entre la diode électroluminescente 2 et chaque barrette 30. En position de blocage, ou d'unterruption, du rayonnement, chaque volet 5 se trouve donc en vue directe de la diode électroluminescente 2. Le dessin des évidements 221 et 222 du bord supérieur 22 de la paroi 21 est établi en procédant comme suit.

L'écartement entre les volets 5 étant imposé par le pas entre les touches 1, ici voisin de 19 mm, l'évidement 222 pour le volet 5 le plus éloigné de la diode électroluminescente 2, appelé dans la suite premier volet, est prévu de façon à ce que, en position enfoncée, ce volet 5 vienne pratiquement toucher le fond du boîtier du clavier. Comme cela sera vu par la suite, une course de 4 mm du volet 5 est suffisante, de façon à commander à coup sûr l'occultation ou l'illumination d'une zone de hauteur égale à 2 mm de la barrette 30. La position de l'évidement 221 pour la barrette 30 correspondante, ou première barrette 30, est donc prévue en conséquence. Sa forme est prévue pour que la direction de la barre sensiblement verticale du L de la section droite de la première barrette 30 ait une direction sensiblement perpendiculaire à celle du faisceau lumineux entre la diode électroluminescente 2 et cette première barrette 30.

L'évidement 222 du volet 5 suivant, ou deuxième volet 5, est prévu pour que, en position enfoncé, ce deuxième volet 5 ne s'interpose pas sur le faisceau lumineux entre la diode électroluminescente 2 et la première barrette 30. Le deuxième volet 5 sera donc plus éloigné du fond du boîtier que le premier volet 5. L'évidemment 221 de la deuxième barrette 30 est prévu en suivant les mêmes règles que précédemment. Alors, compte tenu de l'inclinaison du faisceau lumineux entre la diode électroluminescente 2 et la deuxième barrette 30, par rapport au faisceau lumineux entre cette diode 2 et la première barrette 30, la position de la deuxième barrette 30 est légèrement basculée par rapport à la position de la première barrette 30.

On procède ainsi, de proche en proche, pour tous évidements 221 et 222 du bord 22 de la paroi 21. Les différents faisceaux lumineux issus de la diode électroluminescente 2 qui interceptent les différents volets 5 et barrettes 30 sont contigus dans le plan de la figure 2. On obtient donc une disposition des barrettes 30 et des volets 5 qui suit une courbe dans ce plan. La surface de l'ensemble des cabochons 10 des touches 1 du clavier étant en général plane, la longueur des organes de commande entre chaque cabochon 10 et son volet 5 sera variable. Ces organes de commande, simplement schématisés par des lignes pointillées sur la figure 2, seront décrits ultérieurement.

Comme on peut le constater sur la figure 2, les directions des barres sensiblement verticales des L des sections droites des barrettes 30 ne sont pas rigoureusement perpendiculaires aux directions de faisceaux lumineux entre la diode électroluminescente 2 et ces barrettes 30. Ceci résulte du fait que, compte tenu de la forme particulière des barrettes 30, qui sera décrite dans la suite, un ajustement expérimental de la position de ces barrettes autour de la position définie précédemment, ajustement à la portée de l'homme de métier, permet d'optimiser la transmission optique entre la diode électroluminescente 2 et chaque photodiode 3.

En revenant maintenant à la figure 1, les photodiodes 3 sont protégées de la lumière parasite par un écran 9 de couleur noire mate absorbant la lumière qui remonte de quelques millimètres sur les barrettes 30. Cet écran 9 permet également le positionnement précis des barrettes 30 en regard des photodiodes.

Les barrettes 30 reposent également sur une plaquette 35, à évidements semblables à ceux des parois 21, et disposée à l'opposé des photodiodes 3. Une plaque de mousse élastomère 36 appuie les barrettes 30 contre les photodiodes 3.

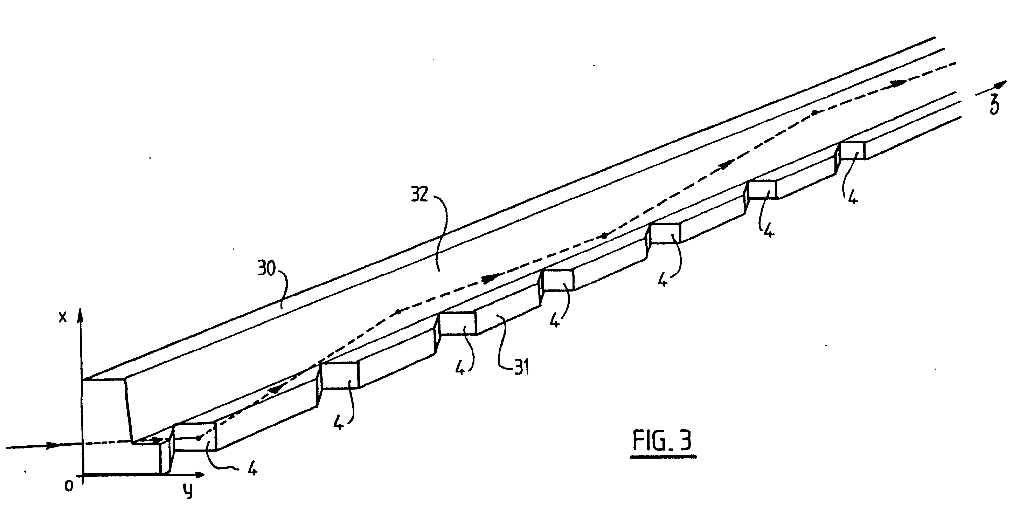

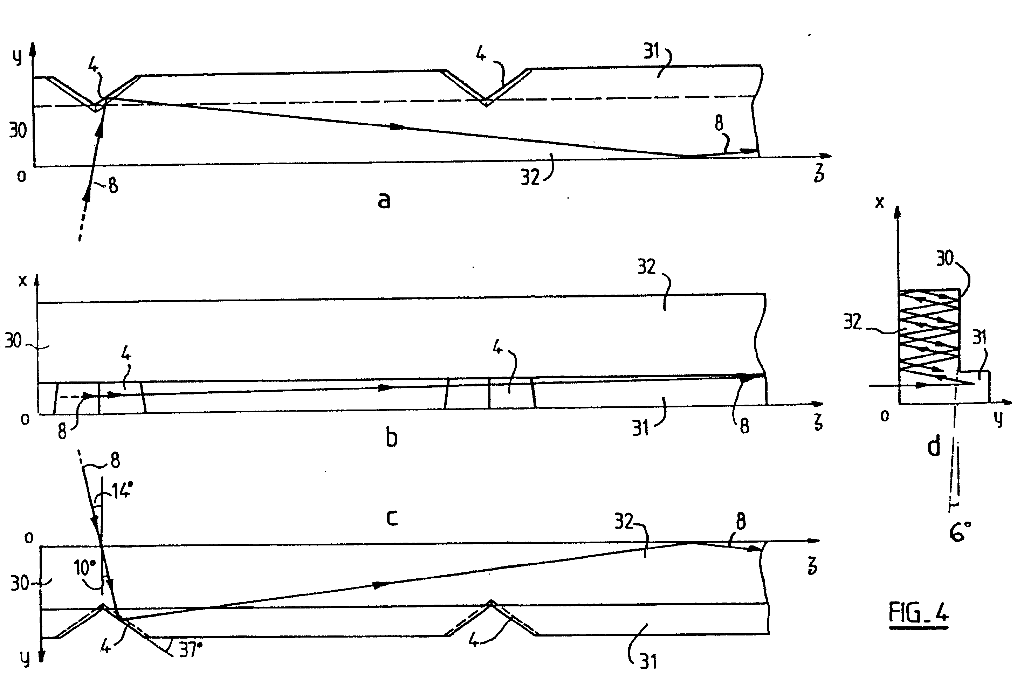

Comme le montrent les figures 3 et 4, chaque barrette 30 est un cylindre d'axe Oz qui comprend un corps 32 et un rebord 31 tous deux de forme générale parallélépipédique. Le corps 32 correspond à une barre du L de la section droite, barre qui s'étend le long d'un axe Ox, et le rebord 31 correspond à l'autre barre de ce L, barre qui s'étend le long d'un axe Oy. Le repère Ox, Oy, Oz est un repère tri-rectangle. La section du corps 32 de la barrette est ici un rectangle de 4,5 mm de haut sur 3 mm de large. La section du rebord 31 de la barrette est ici un carré de 1,5 mm de côté. La longueur d'une barrette dépend du nombre de touches par ligne du clavier, et du pas de ces touches. Elle est ici de l'ordre d'une quarantaine de centimètres.

Dans le rebord 31 sont ménagés, à des distances, sur l'axe Oz, égales au pas entre les touches, des sillons d'axe sensiblement parallèle à l'axe Ox. La face 4 de ces sillons destinée à être du côté de la photodiode 2 est une face plane dont l'intersection avec le plan yOz forme un angle d'ici 37° avec le demi-axe Oz positif et un angle de 53° avec le demi-axe Oy positif, et dont l'intersection avec le plan xOy forme ici un angle de 6° avec le demi-axe Ox négatif et un angle de 84° avec le demi-axe Oy négatif.

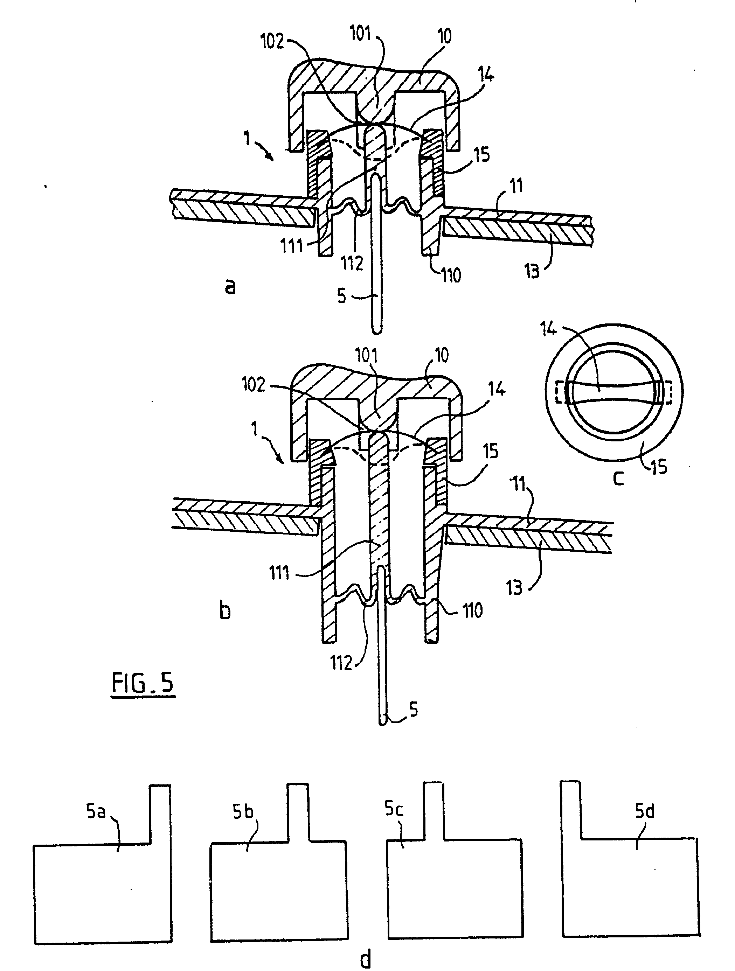

Comme le montrent la figure 5a et la figure 5b, les organes de commande entre chaque cabochon 10 et le volet correspondant 5 font partie d'une unique nappe 11 souple de matière plastique de type élastomère qui recouvre la totalité du boîtier du clavier, sans aucune ouverture vers l'intérieur de celui-ci, qui est ainsi rendu étanche aux poussières d'usure des touches et à la pollution externe.

La nappe 11 comprend, à l'emplacement prévu de chaque touche 1, un corps de touche 110 sensiblement cylindrique, et, sur l'axe du corps de touche 110, un doigt vertical 111, relié au corps de touche 110 par un soufflet 112, du type connu à corrugations. Comme le montrent les figures 5a et 5b, la hauteur du corps de touche 110 et celle du doigt 111 sont variables et dépendent, comme cela a été signalé, de la position de la ligne à laquelle appartient la touche 1 correspondante.

La nappe 11 est ici supportée par une plaque rigide 13, comportant des ouvertures pour laisser passer les corps de touche 110, dont la surface inférieure repose sur le bord supérieur des cloisons 21.

Le cabochon 10 est pourvu intérieurement d'une excroissance arrondie 101 qui appuie au centre d'une lame ressort 14 encastrée dans un anneau de plastique dur 15 sur lequel vient coulisser le bord interne du cabochon 10. Cet anneau 15 repose sur le corps des touches, il assure la rigidité de la touche.

Le ressort 14 est une lame mince, préférablement une lame d'un ruban d'alliage amorphe du type Nickel-Fer-Chrome-Bore de sensiblement 30 microns d'épaisseur, découpée chimiquement ou par estampage pour former une bande de largeur plus faible dans sa partie centrale qu'à ses extrémités, comme le montre la figure 5c. Les extrémités de la lame 14 sont ancrées dans l'anneau pour que la lame 14 forme un arc de cercle, avec une flèche de environ 2 mm. Lorsque la touche est appuyée, la lame 14 se déforme selon la ligne pointillée, en assurant une sensation tactile importante qui empêche l'enfoncement partiel ou la répétition involontaire.

L'excroissance 101 du cabochon 10 est prolongée sur deux côtés par des joues 102 qui s'emboîtent dans la partie supérieure du doigt 111.

Le volet 5, de couleur noire, est ici encastré dans la partie inférieure du doigt 111. Il peut avoir ici quatre formes différentes 5a, 5b, 5c et 5d, illustrées sur la figure 5d, pour s'adapter à la configuration particulière des cabochons 10 sur le clavier, tout en conservant des colonnes 20 rigoureusement rectilignes dans la partie inférieure du boîtier.

Le fonctionnement du clavier qui vient d'être décrit est le suivant. Lorsqu'une diode électroluminescente 2 est commandée pour émettre un rayonnement lumineux, celui-ci se propage en ligne droite dans le canal creux 20 correspondant, jusqu'aux barrettes 30 associées aux touches 1 non enfoncées de la colonne, et jusqu'aux volets 5 associés aux touches 1 enfoncées de la colonne. Comme le boîtier est étanche grâce à la nappe 11, aucune poussière ne perturbe la propagation de lumière. Comme, par ailleurs, aucun franchissement d'interface, ni aucune réflexion ne vient affecter la propagation, l'atténuation du rayonnement lumineux entre la diode électroluminescente 2 et les barrettes 30, ou les volets 5, est pratiquement nulle. Ce résultat est obtenu parce que les volets 5 correspondant aux touches enfoncées, et par conséquent les barrettes 30 correspondant aux touches 1 non enfoncées, sont en vue directe de la diode électroluminescente 2. Les parois 21 ne sont ici réfléchissantes que pour réfléchir la lumière émise par les diodes électroluminescentes 2 hors de son diagramme de rayonnement principal de quelques degrés.

Lorsqu'une touche 1 n'est pas enfoncée, le rayonnement lumineux pénètre dans la barrette 30 correspondante. Son trajet est montré sur les figures 3 et 4, matérialisé par le rayon lumineux portant la référence 8. Comme on le voit sur la figure 4, du fait que l'angle entre la barrette 30 et la colonne 20 est ici de 76°, le rayon 8 arrive sur le plan xOz sous une incidence ici de l'ordre de 14°. Comme la barrette 30 est disposée pour que la partie inférieure du corps 32, située en regard du rebord 31, soit illuminée, le rayon 8, incliné à 10° sur l'axe Oy après réfraction par l'interface d'entrée air-matériau transparent de la barrette 30, vient frapper la surface 4 sur laquelle il se réfléchit. Compte tenu de la position de cette dernière, le rayon 8 est réfléchi dans une direction voisine de celle de l'axe Oz. Comme la photodiode 2 est disposée dans la direction de l'axe Oz, on peut donc dire que la surface 4 constitue un moyen de déflexion du rayonnement lumineux de la diode électroluminescente 2 vers la photodiode 3.

L'orientation de la surface 4 est telle que le rayon lumineux 8 est réfléchi dans une direction dont la projection sur le plan xOz est légèrement inclinée sur l'axe Oz, de façon à se diriger aussi vers les x croissants. Il en résulte, comme le montre la figure 4d, que le rayon, après une première réflexion totale sur la paroi confondue avec le plan xOz, reste prisonnier du corps 32 sur une assez longue distance. En effet, il doit subit ici environ sept réflexions totales sur les parois parallèles au plan xOz du corps 32 avant de se réfléchir totalement sur la paroi supérieure, parallèle au plan yOz du corps 32, paroi qui le renvoie vers la partie inférieure du corps 32, qu'il atteint après environ sept autres réflexions.

Un calcul rigoureux montre que, dans le cas décrit, les réflexions totales sur les parois du corps 32 parallèles au plan xOz se produisent avec une période égale à 2,5 fois la distance entre les touches, c'est-à-dire la distance entre deux surfaces réfléchissantes 4 consécutives.

Il en résulte que le rayon 8 ne peut revenir, au cours de sa propagation dans la barrette 30, sur le rebord 31 qu'après environ 35 pas de touches. Comme les lignes de touches des claviers comportent toujours moins de 35 touches, l'orientation de la surface réfléchissante 4 est donc bien telle que, sur la longueur de la barrette 30, la propagation du rayon lumineux 8 a lieu dans le corps 32 de la barrette 30, et non dans le rebord 31. Ceci a pour résultat une réduction des pertes dans la barrette 30, car dans le corps 32, de structure rigoureusement parallélépipédique, les réflexions sont totales, et le guidage de la lumière effectué avec une atténuation due uniquement au matériau transparent employé. Par contre, la structure du rebord 31 est beaucoup plus complexe, compte tenu des encoches qui y sont faites périodiquement pour créer des surfaces réfléchissantes 4. Ces irrégularités seraient à l'origine de fuites de lumière si celle-ci s'y propageait.

Ainsi, la forme de la barrette 30 est ici particulièrement judicieuse. D'une part la barrette 30 comprend à la fois des moyens de déflexion du rayonnement, à savoir la surface 4, et des moyens de guidage, à savoir le corps 32. Ceci permet d'obtenir une déflexion et un guidage du rayonnement avec un nombre minimal d'interfaces entre l'air et le matériau transparent. D'autre part, l'agencement de la barrette 30 et la disposition de la surface 4 sont tels que les moyens de déflexion répartis périodiquement le long de la barrette 30, sont sans influence défavorable sur la propagation de la lumière dans le corps 32 de la barrette 30.

Sur le plan pratique, on observe, dans le cas décrit, une atténuation de 0,5 dB par pas de touche. La divergence du faisceau d'entrée et les imperfections de l'ensemble font que l'on observe une légère influence de la largeur du rebord sur l'atténuation, alors que celui-ci n'intervient théoriquement pas. Un amincissement progressif du rebord vers le détecteur conduit aux meilleurs résultats expérimentaux. Pour les mêmes raisons, on peut donner aux barrettes 30, au lieu d'une forme cylindrique, une forme de pyramide tronquée correspondant à un léger amincissement vers les photodiodes.

Naturellement, l'étanchéité du boîtier évite le dépôt de poussière sur l'interface d'entrée dans la barrette, et sur l'interface de sortie, ici plane pour une bonne adaptation à la photodiode 2.

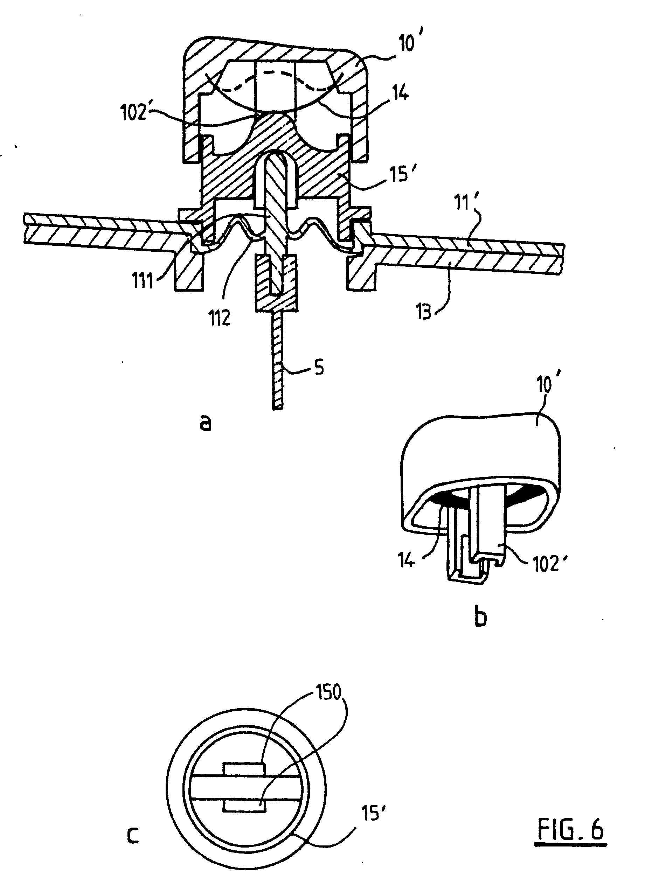

Les figures 6 montrent une première variante de réalisation des touches 1. Sur les figures 6, les éléments identiques à ceux de la figure 5 portent la même référence. Dans la réalisation de la figure 6 la nappe 11' ne comprend pas de corps de touche. La lame ressort 14 est montée dans le cabochon 10', qui comprend aussi deux pattes intérieures de coulissement 102'. L'anneau 15' est un anneau plein pourvu de deux ouvertures 150 pour le guidage des pattes de coulissement 102'. Par rapport à la réalisation des figures 5, la variante de la figure 6 permet d'avoir une lame ressort 14 plus longue, un soufflet 112 plus large, et un meilleur guidage vertical de la touche.

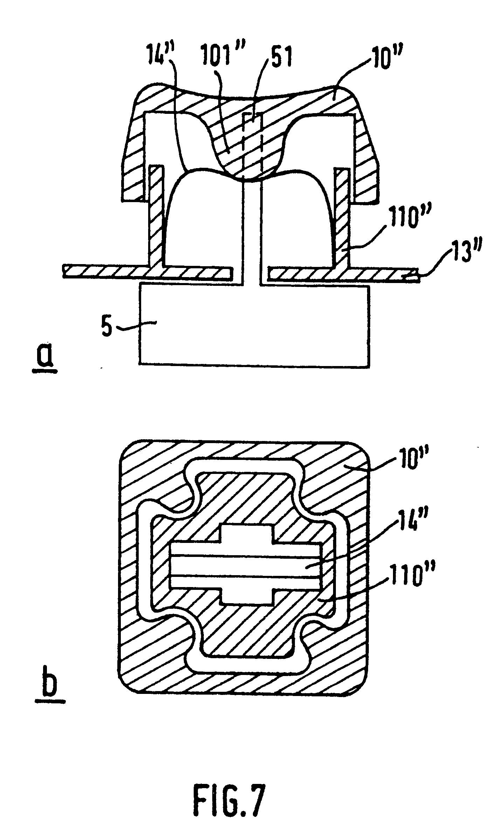

Les figures 7 montrent une deuxième variante de réalisation des touches 1. Dans cette réalisation, chaque corps de touche 110" est solidaire de la plaque rigide supérieure 13" du clavier. Tous les corps de touche 110" sont ainsi obtenus simultanément lors du moulage de la plaque 13". Le cabochon 10" coulisse à l'extérieur du corps de touche 110", et en conséquence, toute poussière due à l'usure retombera à l'extérieur du corps 110" et ne viendra pas perturber la transmission de la lumière à l'intérieur du clavier, ce qui permet de ne pas utiliser de nappe souple comme les nappes 11 et 11' des figures 5 et 6.

Le ressort 14" est ici un simple serpent de ruban, de 1 à 3 mm de large, inséré dans le corps de touche 110", en butée contre la plaque 13". Le ressort 14" est pincé ou collé à ses extrémités. A l'intérieur du cabochon 10", une excroissance arrondie 101" vient s'appuyer contre le ressort 14". Le profil de l'excroissance 101" est ajusté pour obtenir la sensation tactile souhaitée lors de l'enfoncement de la touche. La tige 51 du volet 5 est fixée, par exemple par enfourchement élastique, à l'excroissance 101".

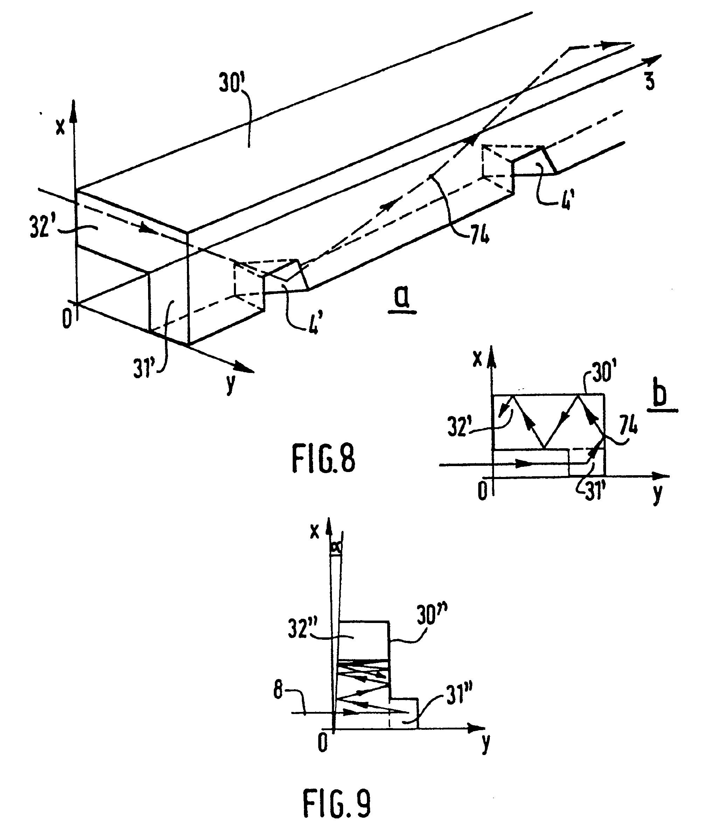

Les figures 8 montrent une première variante de réalisation des barrettes. Dans cette réalisation, chaque barrette 30' est toujours sensiblement en forme de cylindre, de section droite sensiblement en forme de L, avec un corps 32′ et un rebord 31′ comparables à ceux de la barrette 30 de la figure 3. Toutefois, comme le montre la figure 8, le rebord 31′ s'étend verticalement, ici à partir du côté du corps 32′ le plus éloigné des diodes électroluminescentes 2. Des encoches sont pratiquées dans le rebord 31′ pour ménager des surfaces réfléchissantes 4′, inclinées pour que le rayonnement réfléchi reste guidé à l'intérieur du corps 32′, après une réflexion totale en 74, sur la face verticale du corps 32′ la plus éloignée des diodes électroluminescentes 2. Cette variante est particulièrement bien adaptée à la réalisation de claviers plats, et dans lesquels colonnes et barrettes sont perpendiculaires.

La figure 9 montre une deuxième variante de réalisation des barrettes. Dans cette réalisation, chaque barrette 30″, prévue pour être disposée comme la barrette 30 est pourvue d'un corps 32″ de section trapézoïdale, les deux faces sensiblement verticales du corps 32″ n'étant plus parallèles, mais allant en se rapprochant vers le haut, selon un angle α de quelques degrés. De la sorte, le rayonnement guidé reste plus concentré spatialement, ce qui préside à une meilleure détection.

Sur un plan pratique, on notera que la forme simple des barrettes 30, 30′ ou 30″ ne comportant que des surfaces planes sans parties réentrantes, les rend faciles à mouler et contribue à la réduction des coûts de fabrication du clavier de l'invention.

Naturellement, la portée de l'invention n'est pas limitée au clavier qui vient d'être décrit.

Tout d'abord, et compte tenu des diverses formes possibles des volets 5, la disposition des touches, décalable d'une rangée à la suivante par un multiple du quart d'un pas entre touches, peut être quelconque et en particulier conforme au standard alphanumérique des machines à écrire, ou encore correspondre à une disposition régulière pour former un carré ou un rectangle.

Ensuite, on peut aussi envisager un fonctionnement symétrique de celui qui a été décrit, fonctionnement symétrique qui correspond à la transmission de la lumière lors de l'enfoncement d'une touche, au prix d'une transformation évidente du mécanisme des touches.

De même, les diodes électroluminescentes peuvent être remplacées par des diodes lasers, et les photodiodes par des phototransistors, ou encore par des émetteurs et des récepteurs d'autres types de rayonnements électromagnétiques ou de rayonnements ultrasonores. Le clavier peut également être strictement optique en remplaçant les diodes électroluminescentes par des arrivées de fibres optiques ayant une ouverture numérique de 0,3, par exemple, et les photodiodes PIN par une terminaison des barrettes se raccordant par un cône, d'angle au sommet égal à sensiblement 8° et de hauteur 1 cm, à une fibre optique ayant une ouverture numérique de 0,55, par exemple.

L'invention peut être utilisée aussi pour un clavier sans touches où le doigt de l'opérateur vient interrompre le trajet de la lumière, se substituant ainsi aux volets qui ont été décrits.

L'invention peut aussi être utilisée pour la détection et le comptage d'objets quelconques passant dans des passages creux se substituant aux touches, ou pour constituer un panneau à sortie électronique, en utilisant des touches à mémoire mécanique ou des objets marqueurs placés dans des cases à la place des touches, ou, de manière plus générale, pour tout dispositif de transfert de lumière mettant en oeuvre une barrette analogue à celles qui ont été décrites.

## Revendications

1. Clavier comprenant une matrice de touches (1), un émetteur (2) de rayonnement par colonne (20) de touches, un récepteur (3) de rayonnement par ligne (30; 30′; 30″) de touches, des moyens (4) disposés à chaque croisement d'une colonne (20) et d'une ligne (30; 30′; 30″) pour défléchir le rayonnement de l'émetteur (2) correspondant vers le récepteur (3) correspondant, des moyens (5), commandés par chaque touche (1) pour interrompre le rayonnement de l'émetteur (2) correspondant, et des moyens (6, 7) pour commander les émetteurs de façon séquentielle et cyclique, caractérisé par le fait que chaque moyen d'interruption (5) est en vue directe de l'émetteur (2) correspondant, et chaque moyen de déflexion (4) est disposé, sur le trajet du faisceau de l'émetteur (2) correspondant, en aval du moyen d'interruption (5) associé.

2. Clavier selon la revendication 1, dans lequel chaque ligne comprend des moyens de guidage (30; 30′; 30″) du rayonnement défléchi par les moyens de déflexion (4).

3. Clavier selon l'une des revendications 1 ou 2, dans lequel les différents faisceaux d'un même émetteur (2) qui interceptent les différents moyens d'interruption (5) d'une même colonne (20) sont contigus dans un plan perpendiculaire au plan des colonnes (20).

4. Clavier selon l'une des revendications 1 à 3, dans lequel ledit rayonnement est un rayonnement lumineux.

5. Clavier selon la revendication 4, dans lequel les moyens de guidage comprennent une barrette (30; 30′; 30″) de matériau transparent audit rayonnement, et chaque moyen de déflexion comprend une surface réfléchissante (4; 4′) de ladite barrette (30; 30′; 30″).

6. Clavier selon la revendication 5, dans lequel ladite barrette est sensiblement en forme de cylindre (30, 30′, 30″), dont la section droite est sensiblement en forme de L, comprenant un corps (32; 32′; 32″)

parallélépipédique, correspondant à une barre dudit L, et un rebord (31; 31'; 31") sensiblement parallélépipédique, correspondant à l'autre barre dudit L, et des encoches sont pratiquées dans le rebord (31; 31'; 31") pour ménager lesdites surfaces réfléchissantes (4; 4').

7. Clavier selon la revendication 6, dans lequel chaque dite surface réfléchissante (4; 4') est inclinée pour que le rayonnement réfléchi (8) reste guidé, sur la longueur de la barrette (30; 30'; 30") à l'intérieur dudit corps (32; 32'; 32") de la barrette (30; 30'; 30").

8. Clavier selon l'une des revendications 1 à 7, dans lequel chaque touche (1) est pourvue d'un ressort de rappel comprenant une lame souple (14; 14") montée en arc de cercle, dont les extrémités sont fixes et la partie centrale déformable.

9. Clavier selon la revendication 8, dans lequel la lame souple (14) est de largeur plus faible dans sa partie centrale qu'à ses extrémités.

10. Clavier selon l'une des revendications 1 à 9, dans lequel chaque touche (1) comprenant un cabochon (10; 10') et un organe de commande de chaque moyen d'interruption (5), l'ensemble desdits organes de commande fait partie d'une unique nappe (11) souple et étanche recouvrant un boîtier contenant les émetteurs (2), les récepteurs (3), les moyens de déflexion (4) et les moyens d'interruption (5).

11. Clavier selon l'une des revendications 1 à 9, dans lequel chaque touche (1) comprend un cabochon (10") coulissant à l'extérieur d'un corps de touche (101") moulé dans une plaque (13") rigide fermant un boîtier contenant les émetteurs (2), les récepteurs (3), les moyens de déflexion (4) et les moyens d'interruption (5).

**Patentansprüche**

1. Tastenfeld bestehend aus einer Tastenmatrix (1), einem Strahlungssender (2) pro Tastenspalte (20), einem Strahlungsempfänger (3) pro Tastenzeile (30; 30'; 30"), aus an jedem kreuzungspunkt einer Spalte (20) mit einer Zeile (30; 30'; 30") angeordneten Mitteln, um die Strahlung des entsprechenden Senders (2) zum entsprechenden Empfänger (3) hin abzulenken, aus Mitteln (5), die durch jede Taste (1) betätigt werden, um die Strahlung des entsprechenden Senders (2) zu unterbrechen und aus Mitteln (6, 7), um die Sender sequentiell und zyklisch zu steuern, dadurch gekennzeichnet, daß jedes Unterbrechungsmittel (5) vom entsprechenden Sender (2) direkt gesehen wird und jedes Ablenkungsmittel (4) auf dem Weg des Strahls des entsprechenden Senders (2) unterhalb des zugehörigen Unterbrechungsmittels (5) angeordnet ist.

2. Tastenfeld gemäß Anspruch 1, bei welchem jede Zeile Mittel (30; 30'; 30") zum Lenken der von den Ablenkungsmitteln (4) abgelenkten Strahlung enthält.

3. Tastenfeld gemäß einem der Ansprüche 1 oder 2, bei welchem die verschiedenen Strahlen ein und desselben Senders (2), welche die verschiedenen Unterbrechungsmitteln (5) derselben Spalte (20) abfangen, einander in einer zur Ebene der Spalten (20) senkrecht liegenden Ebene berühren.

4. Tastenfeld gemäß einem der Ansprüche 1 bis 3, bei welchem die genannte Strahlung eine Lichtstrahlung ist.

5. Tastenfeld gemäß Anspruch 4, bei welchem die Lenkungsmittel eine Leiste (30; 30'; 30") aus strahlungsdurchlässigem Material umfassen und jedes Ablenkmittel eine reflektierende Fläche (4; 4') der genannten Leiste (30; 30'; 30") umfaßt.

6. Tastenfeld gemäß Anspruch 5, bei welchem die genannte Leiste die Form eines Zylinders (30; 30'; 30") hat, dessen Querschnitt L-förmig ist, und der einen parallelepipeden, einem Balken des genannten L entsprechenden Körper (32; 32'; 32") und eine parallelepipede, dem anderen Balken des genannten L (31; 31'; 31") entsprechende Randleiste aufweist und bei welchem in die Randleiste (31; 31'; 31") kerben eingebracht sind, um die genannten reflektierenden Flächen (4; 4') auszusparen.

7. Tastenfeld gemäß Anspruch 6, bei welchem jede genannte reflektierende Fläche (4; 4') geneigt ist, damit die reflektierte Strahlung (8) über die Länge der Leiste (30; 30'; 30") innerhalb des genannten körpers (32; 32'; 32") der Leiste (30; 30'; 30") gelenkt bleibt.

8. Tastenfeld gemäß einem der Ansprüche 1 bis 7, bei welchem jede Taste (1) mit einer Rückzugfeder versehen ist, die ein biegsames, in Kreisbogenform angeordnetes Plättchen (14 ; 14") umfaßt, dessen Enden feststehend sind und dessen Mittelteil verformbar ist.

9. Tastenfeld gemäß Anspruch 8, bei welchem das biegsame Plättchen (14) im Mittelteil weniger breit ist als an seinen Enden.

10. Tastenfeld gemäß einem der Ansprüche 1 bis 9, bei welchem jede Taste (1) eine Rundkappe (10; 10') und ein Betätigungsorgan für jedes Unterbrechungsmittel (5) enthält und alle genannten Betätigungsorgane zu einer einzigen biegsamen und undurchlässigen Schicht (11) gehören, die ein Gehäuse bedeckt, welches die Sender (2), die Empfänger (3), die Ablenkungsmittel (4) und die Unterbrechungsmittel (5) enthält.

11. Tastenfeld gemäß einem der Ansprüche 1 bis 9, bei welchem jede Taste (1) eine außerhalb eines Tastenkörpers (101") aufschiebbare Rundkappe (10") enthält, bei welchem der Tastenkörper in eine steife Platte (13") geformt ist, welche ein Gehäuse abschließt, daß die Sender (2), die Empfänger (3), die Ablenkungsmittel (4) und die Unterbrechungsmittel (5) enthält.

## Claims

1. Keyboard comprising a matrix of keys (1), a radiation emitter (2) for each column (20) of keys, a radiation receiver (3) for each row (30;30';30") of keys, means (4) disposed at each intersection of a column (20) and a row (30; 30',30") for deflecting the radiation from the corresponding emitter (2) to the corresponding receiver (3), means (5), controlled by each key (1), for interrupting the radiation from the corresponding emitter (2), and means (6,7) for controlling the emitters sequentially and cyclically, characterized in that each interrupting means (5) is in a direct light propagation path from the corresponding emitter (2) and each deflecting means (4) is disposed, on the path of the beam from the corresponding emitter (2), downstream of the associated interrupting means (5).

2. Keyboard as claimed in claim 1, wherein each row includes means (30 ; 30' ; 30") for guiding the radiation deflected by the deflecting means (4).

3. Keyboard as claimed in one of claims 1 or 2, wherein the different beams from a single emitter (2) which intercept the different interrupting means (5) of a single column (20) are contiguous in a plane perpendicular to the plane of the columns (20).

4. Keyboard as claimed in one of claims 1 to 3, wherein said radiation is light radiation.

5. Keyboard as claimed in claim 4, wherein the guiding means include a strip (30 ; 30' ; 30") of material transparent to said radiation, and each deflecting means includes a reflecting surface (4 ; 4') of said strip (30 ; 30' ; 30").

6. Keyboard as claimed in claim 5, wherein said strip is substantially in the form of a cylinder (30 ; 30' ; 30"), whose cross section is substantially in the form of an L, having a parallelepipedic body (32 ; 32' ; 32"), corresponding to a bar of said L and a sustantially parallelepipedic flange (31 ; 31' ; 31"), corresponding to the other bar of said L; and notches are formed in the flange (31 ; 31' ; 31") for providing said reflecting surfaces ( 4 ; 4').

7. Keyboard as claimed in claim 6, wherein each said reflecting surface (4; 4') is slanted so that reflected radiation (8) is guided over the length of the strip (30 ; 30', 30") inside said body of the strip (30 ; 30' ; 30").

8. Keyboard as claimed in one of claims 1 to 7, wherein each key (1) is provided with a biasing spring comprising a flexible blade (14 ; 14") mounted in an arc of a circle, whose ends are fixed and whose central part is deformable.

9. Keyboard as claimed in claim 8, wherein the flexible blade (14) is of smaller width in its central part than at its ends.

10. Keyboard as claimed in one of claims 1 to 9, wherein each key (1) includes a cap (10 ; 10') and a member for controlling each interrupting means (5), the assembly of said controlling members forms part of a single flexible sealing web (11) covering a case containing the emitters (2), the receivers (3), the deflecting means (4) and the interrupting means (5).

11. The keyboard as claimed in one of claims 1 to 9, wherein each key (1) includes a cap (10") sliding outside a key body (101") molded in a rigid plate (13") closing a case containing the emitters (2), the receivers (3), the deflecting means (4) and the interrupting means (5).

FIG .1

EP 0 246 938 B1

FIG. 2

FIG. 3

EP 0 246 938 B1

FIG. 4

**FIG.5**

a

b

c

FIG. 6

14" 101" 51 10"

110"

13"

5

a

10"

14"

110"

b

FIG.7

FIG.8

FIG.9